# EUROPEAN PATENT APPLICATION

(11) **EP 2 704 317 A1**
(43) Date of publication of application: **05.03.2014**
(21) Application number: 11854530.0
(22) Date of filing: 28.10.2011
(51) Int. Cl.: H03F 1/07

(54) **POWER AMPLIFIER DEVICE AND POWER AMPLIFIER CIRCUIT**

(30) Priority: 29.04.2011 CN 201110111346
(71) Applicant: ZTE Corporation, Shenzhen, Guangdong 518057 (CN)
(72) Inventor: CUI, Xiaojun, Shenzhen Guangdong 518057 (CN); CHEN, Huazhang, Shenzhen Guangdong 518057 (CN); LIU, Jianli, Shenzhen Guangdong 518057 (CN)
(74) Representative: Zerbi, Guido Maria
(86) International application number: PCT/CN2011/081480
(87) International publication number: WO 2012/146015

(57) **Abstract**

The present invention relates to a power amplifier apparatus and a power amplifier circuit. The power amplifier circuit uses a Doherty circuit structure, uses a High Electron Mobility Transistor (HEMT) power amplifier to implement a Carrier amplifier with the Doherty circuit structure, and uses a Laterally Diffused Metal Oxide Semiconductor Field Effect Transistor (LDMOS) to implement a Peak amplifier. With the power amplifier apparatus and power amplifier circuit of the present invention, the power amplifier efficiency is improved.

## Description

### Technical Field

The present invention relates to the field of communications, and more especially, to a power amplifier apparatus and power amplifier circuit in the field of communications.

### Background of the Related Art

In face of increasingly fierce competition in the market, the efficiency of the base station products has become the focus of competition in the industry, the efficiency of the main component-power amplifier-that determines the efficiency of the base station has become a top priority, and the industry has invested in the research on the efficiency improvement technologies, wherein, the Doherty technology is a mature technology that is most widely used at present, and the amplifier manufacturers have begun producing and applying the Doherty amplifiers in mass, how to further improve the efficiency in this technology is particularly important.

The Doherty technology was invented by W.H.Doherty in 1936, it was originally used in traveling wave tubes to provide high power transmitter for broadcasting, its structure is simple and highly efficient.

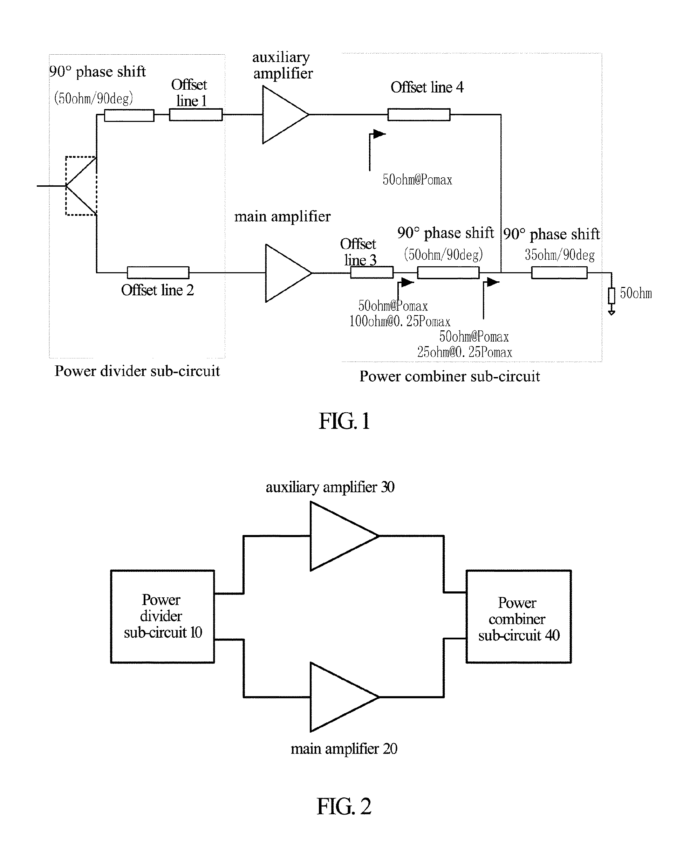

The conventional Doherty structure consists of two power amplifiers: a main power amplifier (also called the carrier power amplifier) and an auxiliary amplifier (also known as Peak Power Amplifier), wherein, the carrier power amplifier works in Class B or AB, and the peak power amplifier works in Class C. The two power amplifiers do not work in turns, but the main amplifier works all the time, and the auxiliary amplifier only works when the preset peak power is reached. The 90 degree quarter-wavelength line after the carrier power amplifier is for impedance transformation, its purpose is to play the role of reducing the apparent impedance of the carrier power amplifier when the auxiliary power amplifier works, thus to ensure that the active load impedance consisting of the auxiliary power amplifier and the subsequent circuits reduces when the auxiliary power amplifier works, thus the output current of the carrier power amplifier is amplified. Due to the quarter-wavelength line after the main power amplifier, in order to make the outputs of the two power amplifiers in phase, 90° phase shift is also needed before the auxiliary power amplifier, as shown in FIG. 1.

The main power amplifier works in Class B, when the input signal is relatively small, only the main power amplifier is in a working condition; when the output voltage of the main power amplifier reaches the peak saturation point, the efficiency can reach 78.5% in theory. If the excitation is doubled at this time, the main power amplifier is already saturated when a half of the peak value is reached, and the efficiency also reaches 78.5% of the maximum, at this time, the auxiliary power amplifier also begins to work together with the main power amplifier. The introduction of the auxiliary power amplifier makes the load reduced from the perspective of the main power amplifier, since the auxiliary power amplifier for the load is equivalent to connecting a negative impedance serially, even if the output voltage of the main power amplifier is saturated and constant, the output power continues to increase (the current flowing through the load becomes larger) due to the load reduction. When the excitation peak is reached, the auxiliary power amplifier also reaches the maximum point of its own efficiency, and the total efficiency of the two power amplifiers is much higher than the efficiency of a single class B power amplifier. The maximum efficiency 78.5% of a single class B power amplifier appears at the peak value, but currently the efficiency 78.5% appears at a half of the peak value, so this kind of system architecture can achieve very high efficiency (each amplifier reaches its maximum output efficiency).

Due to the requirements of the base station system on set-top output power, the requirement for the gain of RF power amplifier is tens of dB, thus one stage of amplification is not enough, generally 3-4 stages of amplification are needed, that is, the pre-drive, the drive and the final stage. Currently, the link structure commonly used in the industry is as follows: the pre-drive stage uses the RF small-signal amplifier, and its working mode is CLASS A; the drive and final stages use the same type of RF power amplifiers (currently, the industry uses the LDMOS devices), the working mode of the drive stage is CLASS AB, and the final stage is the Doherty structure.

With the industry's green concept, the requirements by the operators on the efficiency of the communication system is almost harsh, even with the advanced Doherty technology, the power amplifier efficiency is still unable to meet their increasing demands, it is necessary to make continuous improvements on the basis of the Doherty technology to achieve continuous efficiency improvement.

In the traditional RF power amplifier, the Doherty structure is only applied to the final stage, and the drive stage and the final stage use the same type of power amplifiers, whose advantages are: the supply voltages and the bias modes are the same, thus the design of the bias circuit is simple; since the amplifiers are the same type, the discretion of the mass production is relatively easy to control. However, a fact that cannot be ignored is: the industry's leading LDMOS device has been developed to the eighth generation, its cost is low, but its performance has very limited room for improvement, which cannot meet the environmental protection requirements; in addition, although the power amplifier efficiency is primarily determined by the final stage, the final stage contributes 90% of the operating current, thus further enhancing the efficiency of the final stage has great significance, but the 10% contributed by the drive stage cannot be ignored even more, therefore, it also needs to improve the circuit of the drive stage.

From the signal power spectrum distribution of different schemes of the current communication systems, the 70% -80% energy output by the power amplifier is concentrated around the average power, that is, most of the operating current of the final stage power amplifier which applies the Doherty technology is contributed by the Carrier amplifier, thus enhancing the efficiency of the final stage Carrier amplifier has great significance in improving the efficiency of the entire power amplifier. Meanwhile, the efficiency can be further improved in the drive stage part, which can also better realize the efficiency improvement of the entire power amplifier.

### Summary of the Invention

The technical problem required to be solved by the present invention is to provide a power amplifier apparatus and a power amplifier circuit, to solve the problem that power amplifier efficiency fails to satisfy the requirements.

In order to solve the above technical problem, the present invention provides a power amplifier apparatus, which comprises one or multiple series driver stage power amplifier circuits and a final stage power amplifier circuit connected with an output end of the last driver stage power amplifier circuit, wherein, both the driver stage power amplifier circuit and final stage power amplifier circuit use Doherty circuit structures.

Preferably, the Doherty circuit structure comprises:
a power divider sub-circuit;
one main amplifier and at least one auxiliary amplifier connected with output ends of the power divider sub-circuit;
and a power combiner sub-circuit connected with output ends of the main amplifier and auxiliary amplifier.

Preferably, in the driver stage power amplifier circuit, both the main amplifier and auxiliary amplifier are implemented by using Laterally Diffused Metal Oxide Semiconductor Field Effect Transistor (LDMOS) power amplifiers, or the main amplifier is implemented by using a High Electron Mobility Transistor (HEMT) power amplifier, and the auxiliary amplifier is implemented by using the LDMOS power amplifier.

Preferably, the main amplifier of the final stage power amplifier circuit uses the High Electron Mobility Transistor (HEMT) power amplifier to implement a carrier power amplifier function, and the auxiliary amplifier uses the LDMOS power amplifier to implement a peak power amplifier function.

In order to solve the above technical problem, the present invention provides another kind of power amplifier apparatus, which comprises one or multiple series driver stage power amplifier circuits and a final stage power amplifier circuit connected with an output end of the last driver stage power amplifier circuit, wherein, both the driver stage power amplifier circuit and the final stage power amplifier circuit use the Doherty circuit structures, the driver stage power amplifier circuit uses Laterally Diffused Metal Oxide Semiconductor Field Effect Transistor (LDMOS) power amplifiers to implement a Carrier amplifier and a Peak amplifier with the Doherty circuit structures, and the final stage power amplifier circuit uses a High Electron Mobility Transistor (HEMT) power amplifier to implement the Carrier amplifier with the Doherty circuit structure, and uses a Laterally Diffused Metal Oxide Semiconductor Field Effect Transistor (LDMOS) to implement the Peak amplifier.

In order to solve the above technical problem, the present invention provides a further kind of power amplifier apparatus, which comprises one or multiple series driver stage power amplifier circuits and a final stage power amplifier circuit connected with an output end of the last driver stage power amplifier circuit, wherein, both the driver stage power amplifier circuit and final stage power amplifier circuit use the Doherty circuit structure, use High Electron Mobility Transistor (HEMT) power amplifiers to implement a Carrier amplifier with the Doherty circuit structure, and use Laterally Diffused Metal Oxide Semiconductor Field Effect Transistors (LDMOS) to implement a Peak amplifier.

In order to solve the above technical problem, the present invention further provides a power amplifier circuit of a power amplifier apparatus, wherein, the power amplifier circuit uses the Doherty circuit structure, uses a High Electron Mobility Transistor (HEMT) power amplifier to implement a Carrier amplifier with the Doherty circuit structure, and uses a Laterally Diffused Metal Oxide Semiconductor Field Effect Transistor (LDMOS) to implement a Peak amplifier.

Preferably, the power amplifier circuit is a driver stage or final stage of the power amplifier apparatus.

In order to solve the above technical problem, the present invention provides still another kind of power amplifier circuit of a power amplifier apparatus, which comprises:
a power divider sub-circuit;
a main amplifier connected with an output end of the power divider sub-circuit, wherein, the main amplifier uses a High Electron Mobility Transistor (HEMT) power amplifier to implement a carrier power amplifier function;
at least one auxiliary amplifier connected with an output end of the power divider sub-circuit, wherein, the auxiliary amplifier uses a Laterally Diffused Metal Oxide Semiconductor Field Effect Transistor (LDMOS) power amplifier to implement a peak power amplifier function;
and a power combiner sub-circuit connected with output ends of the main amplifier and auxiliary amplifier.

Preferably, the power amplifier circuit is a driver stage or final stage of the power amplifier apparatus.

In the examples of the present invention, the power amplifier apparatus and the power amplifier circuit use the Doherty technology, and give a brand new combination of the Carrier amplifier and the Peak amplifier. Compared with the prior art, the power amplifier efficiency is improved.

### Brief Description of Drawings

FIG. 1 is a block diagram of a traditional Doherty power amplifier.
FIG. 2 is a functional block diagram of the Doherty circuit structure.
FIG. 3 is a functional block diagram of example 1 according to the present invention.
FIG. 4 is a functional block diagram of example 2 according to the present invention.
FIG. 5 is a functional block diagram of example 3 according to the present invention.
FIG. 6 is a functional block diagram of example 4 according to the present invention.

### Preferred Embodiments of the Present Invention

The power amplifier apparatus of the present invention uses the efficient Doherty circuit structure in the driver stage power amplifier circuit and final stage power amplifier circuit, thereby improving the efficiency of the power amplifier apparatus.

What is particularly related to the present invention is that, the power amplifier apparatus of the present invention includes one or multiple series Driver Stage Power Amplifier circuits and a Final Stage Power Amplifier circuit connected with an output end of the last driver stage power amplifier circuit. Especially, in the present invention, the Driver Stage Power Amplifier circuit uses the Doherty circuit structure.

Specifically, as shown in FIG. 2, the Doherty circuit structure includes: a power divider sub-circuit 10, one main amplifier 20 and at least one auxiliary amplifier 30 connected with output ends of the power divider sub-circuit 10, and a power combiner sub-circuit 40 connected with output ends of the main amplifier and auxiliary amplifier.

Understandably, the main amplifier 20, also called a Carrier amplifier, provides main power amplifier functions, such as providing power amplifier continuously. The auxiliary amplifier, also called the Peak amplifier, provides auxiliary power amplifier functions, such as only working in specified conditions (e.g. a preset peak value is reached). As shown in FIG. 1, the power divider sub-circuit 10 includes a series of functional devices such as power divider, 90° quarter-wavelength line, phase offset line and so on, the power combiner sub-circuit 40 includes a series of functional apparatus such as 90° quarter-wave lines, phase offset line, impedance converter and so on, and the specific types, models and connection relationship of the devices are designed, chosen and matched according to specific implementation requirements, which are not limited by the present invention.

The main amplifier and auxiliary amplifier can be implemented by using various power amplifiers, and preferably, are both implemented by using a Laterally Diffused Metal Oxide Semiconductor Field Effect Transistor (LDMOS) power amplifier, or the main amplifier is implemented by using a High Electron Mobility Transistor (HEMT) power amplifier, and the auxiliary amplifier is implemented by using the LDMOS power amplifier.

In the prior art, the Final Stage Power Amplifier circuit is also implemented by using the Doherty circuit structure as shown in FIG. 2, and preferably, the High Electron Mobility Transistor (HEMT) power amplifier is used to implement a carrier power amplifier function, and the LDMOS power amplifier is used to implement a peak power amplifier function.

The examples of the present invention will be described in detail in combination with the accompanying drawings below. It should be noted that the examples and the characteristics in the examples according to the present invention can be combined with each other in the condition of no conflict.

### Example 1

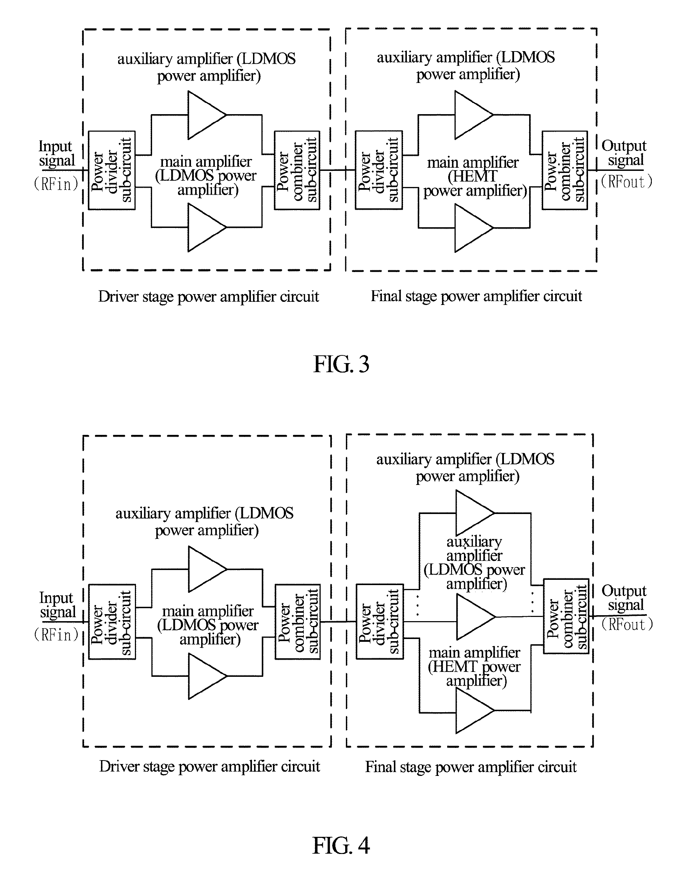

Example 1 of the power amplifier apparatus is as shown in FIG. 3, and in the example 1, a driver stage uses a two-way Doherty structure circuit, and uses a LDMOS power amplifier to implement a carrier power amplifier function and a peak power amplifier function, and a final stage uses the two-way Doherty structure circuit, uses a High Electron Mobility Transistor (HEMT) power amplifier to implement the carrier power amplifier function, and uses the LDMOS power amplifier to implement the peak power amplifier function.

Specifically, an amplifier part of the driver stage is implemented by using the Doherty circuit structure, and both the Carrier amplifier and Peak amplifier of the amplifier part use the Laterally Diffused Metal Oxide Semiconductor Field Effect Transistor (LDMOS, based on Si) power amplifiers;
the Doherty circuit is used at the driver stage, meanwhile, the final stage is implemented with a newly combined two-way Doherty circuit structure.

With regard to a two-way structure Doherty (including traditional two-way symmetrical Doherty and asymmetrical Doherty and so on) of the final stage and an architecture of one Carrier as well as one Peak evolved on the basis of this, the High Electron Mobility Transistor (HEMT, based on GaN) power amplifier is used as the Carrier amplifier and the Laterally Diffused Metal Oxide Semiconductor Field Effect Transistor (LDMOS, based on Si) power amplifier is used as the Peak amplifier to implement an efficiency improvement.

### Example 2

Example 2 of the power amplifier apparatus is as shown in FIG. 4, and in the example 2, a driver stage uses a two-way Doherty structure circuit, and uses a LDMOS power amplifier to implement a carrier power amplifier function and a peak power amplifier function, and a final stage uses the two-way Doherty structure circuit, and uses a High Electron Mobility Transistor (HEMT) power amplifier to implement the carrier power amplifier function, and uses the LDMOS power amplifier to implement the peak power amplifier function.

Specifically, an amplifier part of the driver stage is implemented by using the Doherty circuit structure, and both the Carrier amplifier and Peak amplifier of the amplifier part use the LDMOS power amplifiers;
the Doherty circuit is used at the driver stage, meanwhile, the final stage is implemented with a newly combined multi-way Doherty circuit structure.

With regard to a multi-way structure Doherty of the final stage and an architecture of one Carrier amplifier as well as multiple Peak amplifiers evolved on the basis of this, the High Electron Mobility Transistor (HEMT) power amplifier is used as the Carrier amplifier and the LDMOS power amplifiers are used as the multiple Peak amplifiers to implement efficiency improvement.

### Example 3

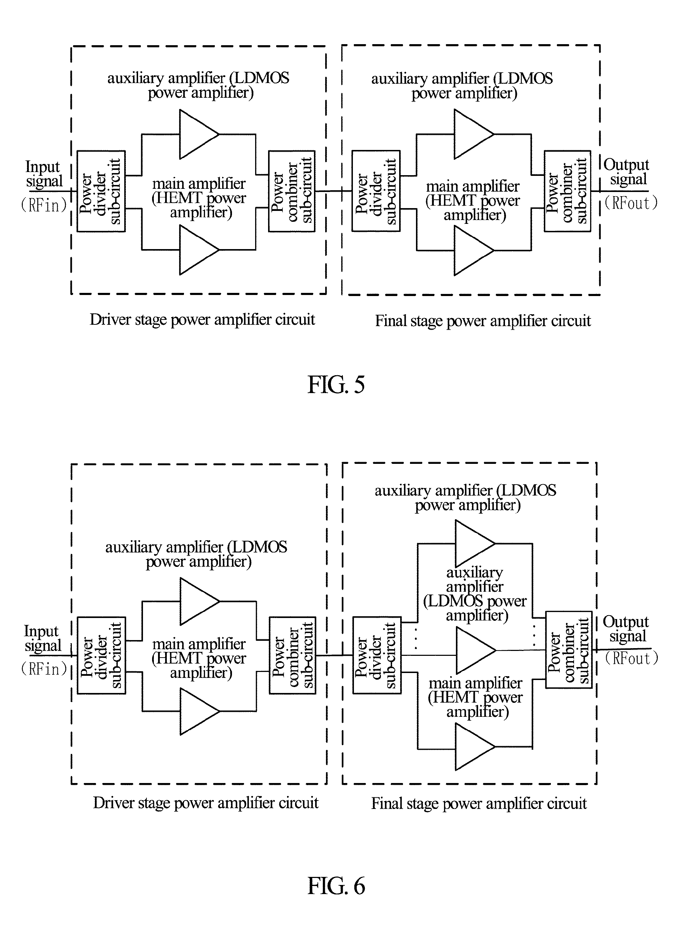

Example 3 of the power amplifier apparatus is as shown in FIG. 5, the circuit structure in the example 3 is the same as that in the example 1, and the difference is that a driver stage uses a High Electron Mobility Transistor (HEMT) power amplifier to implement a carrier power amplifier function, and uses a LDMOS power amplifier to implement a peak power amplifier function.

### Example 4

Example 4 of the power amplifier apparatus is as shown in FIG. 6, the circuit structure in the example 4 is the same as that in the example 2, and the difference is that a driver stage uses a High Electron Mobility Transistor (HEMT) power amplifier to implement a carrier power amplifier function, and uses a LDMOS power amplifier to implement a peak power amplifier function.

The key point of the present invention is that: the driver stage uses an efficient Doherty circuit structure to achieve an efficiency improvement of the driver stage; meanwhile, the driver stage or final stage also uses a breakthrough brand new combination mode, fully utilizes an advantage of high efficiency of the HEMT power amplifier, and uses the HEMT power amplifier as the Carrier amplifier to improve efficiency and achieve an optimal performance; and utilizes advantages of high technology maturity, low cost and full range of apparatus of the LDMOS power amplifier, and uses the LDMOS power amplifier as the Peak amplifier to achieve an optimal cost and achieve a perfect combination of performance and cost ultimately.

With the method and apparatus of the present invention, compared with the existing driver stage using the CLASS AB mode and both the final stage Carrier amplifier and Peak amplifier using the Doherty power amplifier of the LDMOS, the whole power amplifier efficiency can be greatly improved;

The LDMOS apparatus have been developed maturely with a full range of types and low costs. The driver uses a mode of the LDMOS device plus the Doherty structure, which not only improves the efficiency, but also guarantees the costs.

Currently, as the cost of the GaN HEMT power amplifier is 5 to 10 times higher than that of the Si LDMOS, therefore, compared with both the Carrier amplifier and Peak amplifier using the final stage Doherty power amplifier of the LDMOS, the performance of the final stage power amplifier part in the method and apparatus described in the present invention is improved, meanwhile, the cost will also be reduced;

In addition, since the LDMOS has been well developed, products of all the manufacturers are comparatively complete, and product categories with different power levels are numerous. In applications, the LDMOS products with different models can be used as the Peak amplifiers according to different power levels, which are flexibly combined with the Carrier amplifiers using the HEMT power amplifiers and implemented by using different Doherty structures (such as symmetrical, asymmetrical and multi-way and so on) as needed, thus, not only the cost and performance are balanced, but also convenience and flexibility for use are guaranteed.

The specific steps for implementing the power amplifier apparatus of the present invention include:
1. according to different implementation requirements, firstly determining a model of the HEMT power amplifier used by a final stage Carrier amplifier.
2. according to different implementation requirements, comparing, analyzing and determining a Doherty structure to be used.
3. according to different implementation requirements, determining a model of the LDMOS power amplifier used by a final stage Peak amplifier.
4. according to a final stage gain, determining the model of the HEMT power amplifier or LDMOS power amplifier used by a driver stage Carrier amplifier, and the model of the LDMOS power amplifier used by a driver stage Peak amplifier.
5. completing a matching design of the amplifiers of the final stage and driver stage and a design for the parts of power divider and power combiner in the block diagram.
6. completing a design for the rest parts of the apparatus of the present invention.

A specific example is as follows: with regard to the design of 85W Doherty power amplifier (PAR: 6dB) used by the 2.1GHz UMTS, two power amplifiers whose total saturation power should be at least more than 360W need to be used to make a final stage design. In combination with the existing devices of power amplifier manufacturers, it could be achieved by using two 200W-LDMOS power amplifiers with the symmetrical Doherty structure, and according to the current technology level of devices in the industry, the single final stage power amplifier efficiency thereof is about 52%; however, if the method based on the present invention is used to implement it (wherein, the Carrier amplifier uses a 200W HEMT power amplifier and the Peak amplifier uses a 200W LDMOS power amplifier), the single final stage power amplifier efficiency thereof is about 55%, which raises by about 6%; and if two HEMT power amplifiers are used to implement it, the single final stage power amplifier efficiency is also about 55%, but the cost will be 5 to 10 times higher than that achieved by the method based on the present invention.

With regard to the Doherty driver design, since the final stage needs to use the saturation power more than 360W at least, and the current 2.1GHz final stage power amplifier Doherty gain is about 16dB, therefore, the driver stage can use two 10W-LDMOS power amplifiers to implement the design of amplifier part of the driver stage, and thus, compared with the original CLASS AB design, efficiency of the driver stage can further be improved by about 20% (for example, the efficiency of the driver stage is at 15% when the CLASS AB design is used and it can be up to 18% when the Doherty design is used).

Therefore, with the method and apparatus of the present invention, the efficiency will be greatly improved in a premise of guaranteeing the costs.

The present invention also provides a power amplifier circuit of a power amplifier apparatus, the power amplifier circuit uses the Doherty circuit structure, uses a High Electron Mobility Transistor (HEMT) power amplifier to implement a Carrier amplifier with the Doherty circuit structure, and uses a Laterally Diffused Metal Oxide Semiconductor Field Effect Transistor (LDMOS) to implement a Peak amplifier. Specifically, the power amplifier circuit can be a driver stage or final stage of the power amplifier apparatus, and specifically includes:
a power divider sub-circuit 10;
a main amplifier 20 connected with an output end of the power divider sub-circuit, wherein, the main amplifier uses the High Electron Mobility Transistor (HEMT) power amplifier to implement a carrier power amplifier function;
at least one auxiliary amplifier 30 connected with the output end of the power divider sub-circuit, wherein, the auxiliary amplifier uses a Laterally Diffused Metal Oxide Semiconductor Field Effect Transistor (LDMOS) power amplifier to implement a peak power amplifier function;
and a power combiner sub-circuit 40 connected with output ends of the main amplifier and auxiliary amplifier.

In conclusion, the implementation of the present invention is simple, and its design and debugging are convenient and flexible, and the cost is low, those skilled in the field can easily implement the present invention with this specification. Within the working frequency range of the Doherty power amplifier, its efficiency specification can be greatly improved, and the apparatus can be widely used in the designs of a variety of Doherty power amplifiers.

The purpose of the present invention is to newly combine the Carrier amplifier and the Peak amplifier in the final stage power amplifier using the Doherty technology, the newly combined structure is used to improve the efficiency of the Carrier amplifier of the driver stage or final stage; the high efficient circuit structure is used in the driver stage, thus to achieve the significant improvement of the overall Doherty power amplifier efficiency from two aspects.

### Industrial Applicability

In the examples of the present invention, the power amplifier apparatus and power amplifier circuit use a Doherty technology, and provide a brand new combination of the Carrier amplifier and Peak amplifier. Compared with the prior art, the power amplifier efficiency is improved.

## Claims

1. A power amplifier apparatus, comprising one or multiple series driver stage power amplifier circuits and a final stage power amplifier circuit connected with an output end of a last driver stage power amplifier circuit, wherein, both the driver stage power amplifier circuit and final stage power amplifier circuit use Doherty circuit structures.

2. The power amplifier apparatus according to claim 1, wherein, the Doherty circuit structure comprises:
a power divider sub-circuit;
one main amplifier and at least one auxiliary amplifier connected with output ends of the power divider sub-circuit;
and a power combiner sub-circuit connected with output ends of the main amplifier and the auxiliary amplifier.

3. The power amplifier apparatus according to claim 2, wherein, in the driver stage power amplifier circuit, both the main amplifier and the auxiliary amplifier are implemented by using Laterally Diffused Metal Oxide Semiconductor Field Effect Transistor (LDMOS) power amplifiers, or the main amplifier is implemented by using a High Electron Mobility Transistor (HEMT) power amplifier, and the auxiliary amplifier is implemented by using the LDMOS power amplifier.

4. The power amplifier apparatus according to claim 2, wherein, the main amplifier of the final stage power amplifier circuit uses the High Electron Mobility Transistor (HEMT) power amplifier to implement a carrier power amplifier function, and the auxiliary amplifier uses the LDMOS power amplifier to implement a peak power amplifier function.

5. A power amplifier apparatus, comprising one or multiple series driver stage power amplifier circuits and a final stage power amplifier circuit connected with an output end of a last driver stage power amplifier circuit, wherein, both the driver stage power amplifier circuit and the final stage power amplifier circuit use Doherty circuit structures, the driver stage power amplifier circuit uses Laterally Diffused Metal Oxide Semiconductor Field Effect Transistor (LDMOS) power amplifiers to implement a Carrier amplifier and a Peak amplifier with the Doherty circuit structures, and the final stage power amplifier circuit uses a High Electron Mobility Transistor (HEMT) power amplifier to implement the Carrier amplifier with the Doherty circuit structure, and uses a Laterally Diffused Metal Oxide Semiconductor Field Effect Transistor (LDMOS) to implement the Peak amplifier.

6. A power amplifier apparatus, comprising one or multiple series driver stage power amplifier circuits and a final stage power amplifier circuit connected with an output end of a last driver stage power amplifier circuit, wherein, both the driver stage power amplifier circuit and the final stage power amplifier circuit use Doherty circuit structures, use High Electron Mobility Transistor (HEMT) power amplifiers to implement Carrier amplifiers with the Doherty circuit structures, and use Laterally Diffused Metal Oxide Semiconductor Field Effect Transistors (LDMOS) to implement Peak amplifiers.

7. A power amplifier circuit of a power amplifier apparatus, wherein, the power amplifier circuit uses a Doherty circuit structure, uses a High Electron Mobility Transistor (HEMT) power amplifier to implement a Carrier amplifier with the Doherty circuit structure, and uses a Laterally Diffused Metal Oxide Semiconductor Field Effect Transistor (LDMOS) to implement a Peak amplifier.

8. The power amplifier circuit according to claim 7, wherein, the power amplifier circuit is a driver stage or final stage of the power amplifier apparatus.

9. A power amplifier circuit of a power amplifier apparatus, comprising:
a power divider sub-circuit;
a main amplifier connected with an output end of the power divider sub-circuit, wherein, the main amplifier uses a High Electron Mobility Transistor (HEMT) power amplifier to implement a carrier power amplifier function;
at least one auxiliary amplifier connected with an output end of the power divider sub-circuit, wherein, the auxiliary amplifier uses a Laterally Diffused Metal Oxide Semiconductor Field Effect Transistor (LDMOS) power amplifier to implement a peak power amplifier function; and
a power combiner sub-circuit connected with output ends of the main amplifier and the auxiliary amplifier.

10. The power amplifier circuit according to claim 9, wherein, the power amplifier circuit is a driver stage or final stage of the power amplifier apparatus.
